# EUROPEAN PATENT SPECIFICATION

(11) **EP 3 869 704 B1**
(45) Date of publication and mention of the grant of the patent: **11.02.2026**
(21) Application number: 19888060.1
(22) Date of filing: 18.11.2019
(51) Int. Cl.: H04B 7/06, H03F 1/02, H03F 1/32, H03F 3/24, H03F 3/68, H03F 3/189

(54) **POWER AMPLIFICATION CIRCUIT FOR SUB-ARRAY BEAM FORMING SYSTEM, AND SUB-ARRAY BEAM FORMING SYSTEM**
LEISTUNGSVERSTÄRKUNGSSCHALTUNG FÜR EIN UNTERARRAY-STRAHLFORMUNGSSYSTEM UND UNTERARRAY-STRAHLFORMUNGSSYSTEM
CIRCUIT D'AMPLIFICATION DE PUISSANCE POUR SYSTÈME DE FORMATION DE FAISCEAUX DE SOUS-RÉSEAU ET SYSTÈME DE FORMATION DE FAISCEAUX DE SOUS-RÉSEAU

(30) Priority: 23.11.2018 CN 201811408462
(43) Date of publication of application: 25.08.2021
(73) Proprietor: Huawei Technologies Co., Ltd., Longgang District Shenzhen, Guangdong 518129 (CN)
(72) Inventor: CHENG, Qianfu, Shenzhen, Guangdong 518129 (CN); CAI, Hua, Shenzhen, Guangdong 518129 (CN); WANG, Guangjian, Shenzhen, Guangdong 518129 (CN); HUANG, Jingjing, Shenzhen, Guangdong 518129 (CN); LIANG, Dong, Shenzhen, Guangdong 518129 (CN)
(74) Representative: Gill Jennings & Every LLP
(86) International application number: PCT/CN2019/119109
(87) International publication number: WO 2020/103779

(56) References cited:
- WO-A1-2015/168403
- WO-A1-2017/107063
- WO-A1-2017/193199
- CN-A- 101 247 153
- CN-A- 103 166 666
- CN-A- 103 907 283
- CN-A- 107 241 114
- US-A1- 2011 151 806
- US-A1- 2013 049 858

## Description

### TECHNICAL FIELD

This application relates to communications technologies, and in particular, to a power amplifier circuit used in a subarray beamforming system and a subarray beamforming system.

### BACKGROUND

To meet requirements of 5-generation new radio (5-Generation New Radio, 5G NR for short) for a rapid increase in a data rate and a communications capacity, more and more studies show that a subarray beamforming system has advantages such as excellent performance, low power consumption, and low hardware complexity, and thus is considered to be used to overcome a problem of a large free loss in 5G NR.

In the subarray beamforming system, to meet a requirement of effective isotropic radiated power (Effective Isotropic Radiated Power, EIRP for short) of the system, one power amplifier is usually configured for each subarray antenna. Therefore, the entire system includes many power amplifiers. To ensure system reliability and heat dissipation efficiency, a high-efficiency power amplifier is indispensable. In a conventional subarray beamforming system, an AB-type power amplifier is used. To ensure high linearity of a system, the power amplifier needs to work in a deep power back-off area. However, efficiency of the AB-type power amplifier in the power back-off area is very low.

US 2013/049858 A1 discloses an envelope tracking system for MIMO.

US 2011/151806 A1 discloses a multiple envelope tracking system for an active antenna array.

### SUMMARY

The invention is defined by independent claim 1. Further embodiments are described by the dependent claims.

### BRIEF DESCRIPTION OF DRAWINGS

FIG. 1 is a schematic structural diagram of an embodiment 1 of a power amplifier circuit used in a subarray beamforming system according to this application;
FIG. 2 is a schematic structural diagram of an embodiment 2 of a power amplifier circuit used in a subarray beamforming system according to this application;
FIG. 3 is a schematic structural diagram of an embodiment 3 of a power amplifier circuit used in a subarray beamforming system according to this application;
FIG. 4 is a schematic structural diagram of an embodiment 4 of a power amplifier circuit used in a subarray beamforming system according to this application;
FIG. 5 is a schematic structural diagram of an embodiment 1 of a subarray beamforming system according to this application; and
FIG. 6 is a schematic structural diagram of an embodiment 2 of a subarray beamforming system according to this application.

### DESCRIPTION OF EMBODIMENTS

To make objectives, technical solutions, and advantages of this application clearer, the following clearly and completely describes the technical solutions in this application with reference to the accompanying drawings in this application. Definitely, the described embodiments are merely a part rather than all of the embodiments of this application.

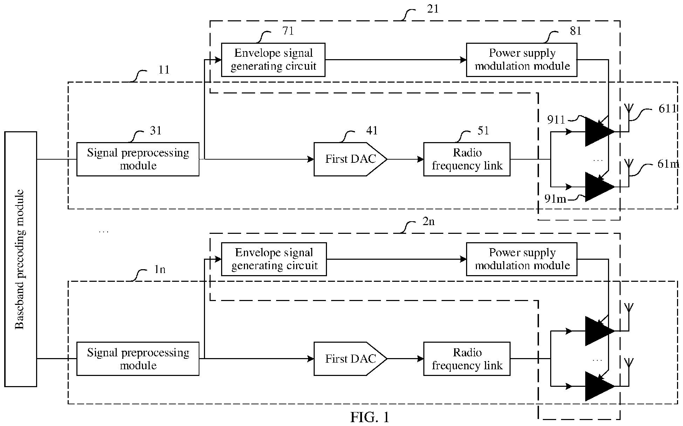

FIG. 1 is a schematic structural diagram of an embodiment 1 of a power amplifier circuit used in a subarray beamforming system according to this application. As shown in FIG. 1, the subarray beamforming system includes a plurality of transmit channels (11, ..., and 1n), and the power amplifier circuit includes a plurality of power amplifier sub-circuits (21, ..., and 2n). One power amplifier sub-circuit is correspondingly disposed for each transmit channel (the transmit channel 11 corresponds to the power amplifier sub-circuit 21, ..., and the transmit channel 1n corresponds to the power amplifier sub-circuit 2n). The power amplifier sub-circuit is configured to perform power amplification processing on the transmit channel corresponding to the power amplifier sub-circuit.

For example, the transmit channel 11 includes a signal preprocessing module 31, a first digital-to-analog converter (Digital Analog Converter, DAC for short) 41, a radio frequency link 51, and a subarray module that are sequentially connected. The subarray module includes at least one antenna array module (611, ..., and 61m). The power amplifier sub-circuit 21 includes an envelope signal generating circuit 71, a power supply modulation module 81, and a power amplifier unit that are sequentially connected. The power amplifier unit includes at least one power amplifier (911, ..., and 91m). One power amplifier is correspondingly disposed for each antenna array module (to be specific, the antenna array module 611 corresponds to the power amplifier 911, ..., and the antenna array module 61m corresponds to the power amplifier 91m). An input end of the envelope signal generating circuit 71 is connected to an output end of the signal preprocessing module 31. The power amplifier 911 is disposed at an input end of the antenna array module 611, ..., and the power amplifier 91m is disposed at an input end of the antenna array module 61m. Optionally, the input end of the envelope signal generating circuit 71 may be further connected to an output end of the first digital-to-analog converter 41 or an output end of the radio frequency link 51. The signal preprocessing module 31 on the transmit channel 11 preprocesses a precoded baseband signal, and this may be implemented by using algorithms such as crest factor reduction (Crest Factor Reduction, CFR for short), digital pre-distortion (Digital pre-Distortion, DPD for short), and time alignment. The signal preprocessing module 31 transmits the preprocessed baseband signal to the connected first DAC 41 and the envelope signal generating circuit 71 on the corresponding power amplifier sub-circuit 21. The first DAC 41 converts the preprocessed baseband signal into an analog signal, and transmits the analog signal to the connected radio frequency link 51. The radio frequency link 51 performs up-conversion, signal amplification, and filtering processing on the analog signal to generate a radio frequency modulation signal, and transmits the radio frequency modulation signal to the antenna array modules 611, ..., and 61m. The envelope signal generating circuit 71 may generate an envelope signal shared by all antenna array modules (611, ..., and 61m) in the subarray module on the transmit channel 11. The envelope signal generating circuit 71 generates an envelope signal based on the preprocessed baseband signal, and then transmits the envelope signal to the connected power supply modulation module 81. The power supply modulation module 81 implements envelope following of a power supply voltage of the power amplifier unit, generates, under control of the envelope signal, an output voltage that dynamically changes with the envelope signal, and transmits the dynamically changing output voltage to connected power amplifiers 911, ..., and 91m. In other words, the drain (or collector) of the power amplifiers is used as a drain (or collector) voltage. The power amplifier 911 amplifies, under modulation of the dynamically changing output voltage (the drain (or collector) voltage), a radio frequency modulation signal transmitted to the connected antenna array module 611. The power amplifier 91m amplifies, under modulation of the dynamically changing output voltage (the drain (or collector) voltage), a radio frequency modulation signal transmitted to the connected antenna array module 61m. The antenna array modules 611, ..., and 61m implement analog beamforming and signal transmission. Compared with a power amplification technology that is based on a constant voltage power supply, in this application, all power amplifiers work in an envelope tracking mode. Therefore, average efficiency of system power amplification is greatly improved.

A structure of another transmit channel is similar to the structure of the transmit channel 11, and details are not described herein again. In this application, envelope signal generating circuits corresponding to different transmit channels may select different envelope shaping algorithms based on system requirements, and then each transmit channel may use envelope signals that are not completely the same to control the power supply modulation module to generate an output voltage that dynamically changes with the envelope signals, so as to implement different power amplification on different transmit channels. In this way, performance is optimized.

In this application, the subarray beamforming system includes a plurality of parallel transmit channels. Each transmit channel includes one subarray module, each subarray module includes a plurality of antenna array modules, one transmit channel corresponds to one power amplifier sub-circuit, and one antenna array module in each subarray module in the transmit channel corresponds to one power amplifier. Power amplifier units corresponding to subarray modules in different transmit channels use different power supply modulation modules and different envelope signal generating circuits, to generate separate envelope signals for the power amplifier units of the transmit channels. All power amplifiers corresponding to antenna array modules in a subarray module in a same transmit channel use a same power supply modulation module and a same envelope signal generating circuit. According to different actual requirements, envelope signals of the transmit channels may be processed differently, so that envelope tracking power amplifiers work in different states, different effects are achieved, and the power amplification efficiency of the subarray beamforming system is improved. In addition, in an entire design process, a hardware structure of the system does not need to be changed, and compatibility with the conventional technology is achieved to a maximum extent.

The following uses the power amplifier sub-circuit 21 as an example to describe in detail the technical solution of the power amplifier circuit used in the subarray beamforming system shown in FIG. 1.

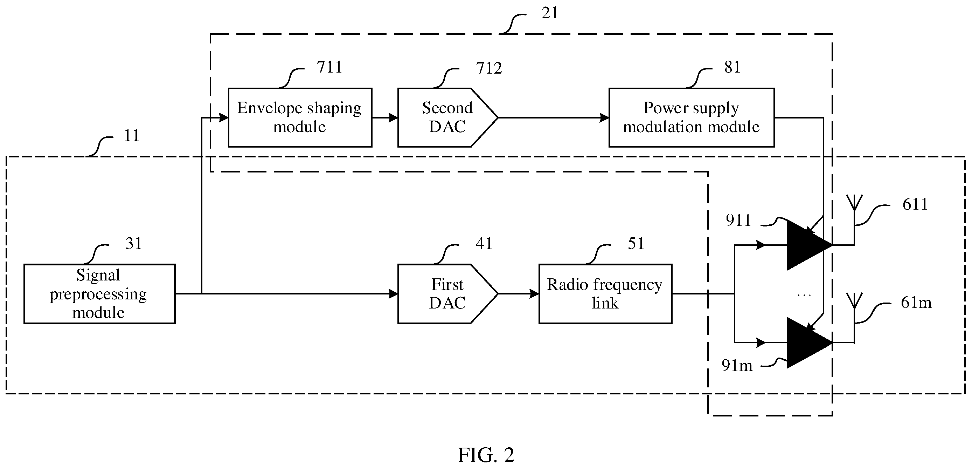

FIG. 2 is a schematic structural diagram of an embodiment 2 of a power amplifier circuit used in a subarray beamforming system according to this application. As shown in FIG. 2, an envelope signal generating circuit includes an envelope shaping module 711 and a second DAC 712 that are sequentially connected, and an input end of the envelope shaping module 711 is connected to an output end of a signal preprocessing module 31. An output end of the second DAC 712 is connected to an input end of a power supply modulation module 81.

In this application, the envelope shaping module 711 may generate an envelope signal shared by a subarray module on each transmit channel in a digital domain, and envelope signal generating circuits corresponding to different transmit channels may select different envelope shaping algorithms based on system requirements, to achieve optimal performance. The second DAC 712 converts a digital envelope signal into an analog envelope signal. The signal preprocessing module 31 generally preprocesses a baseband signal by using algorithms such as CFR and DPD, the envelope shaping module 711 generates a digital envelope signal by using an envelope shaping algorithm, and then the second DAC 712 converts the digital envelope signal into an analog envelope signal. In this application, a time alignment algorithm may be used in a baseband to implement time alignment between an envelope signal and a radio frequency signal on a transmit channel. Therefore, in the digital domain, a delay line and analog envelope detection are omitted, a design requirement of an envelope modulator is lowered, and most of envelope signal processing is transferred to a digital baseband, which is more flexible.

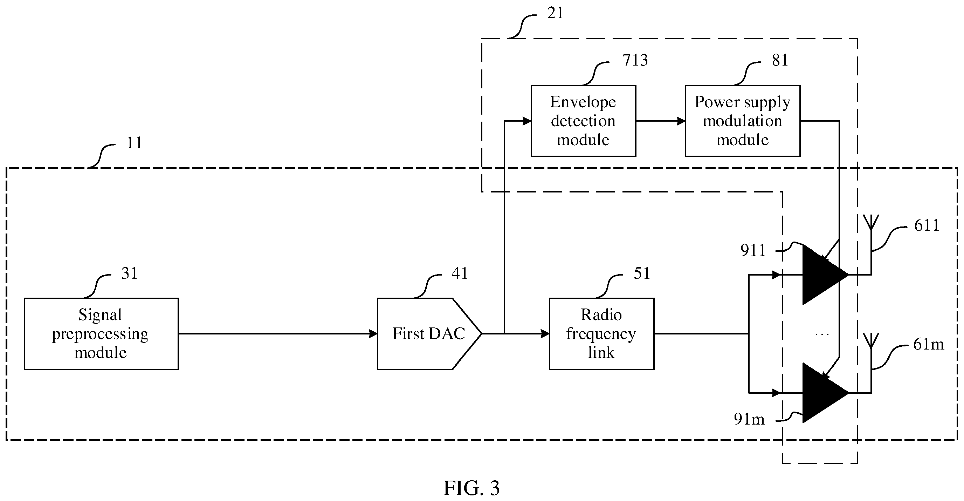

FIG. 3 is a schematic structural diagram of an embodiment 3 according to the granted invention. As shown in FIG. 3, an envelope signal generating circuit includes an envelope detection module 713. An input end of the envelope detection module 713 is connected to an output end of a first DAC 41. Optionally, the input end of the envelope detection module 713 is connected to an output end of a radio frequency link 51. and an output end of the envelope detection module 713 is connected to an input end of a power supply modulation module 81.

In this application, because an envelope signal exists at any location on a transmit channel, the envelope detection module 713 may be disposed at different locations on the transmit channel, and the envelope detection module 713 directly generates an analog envelope signal. The envelope detection module 713 is easy to implement, no additional baseband algorithm or DAC is required, and the envelope signal can be directly used by the power modulation module.

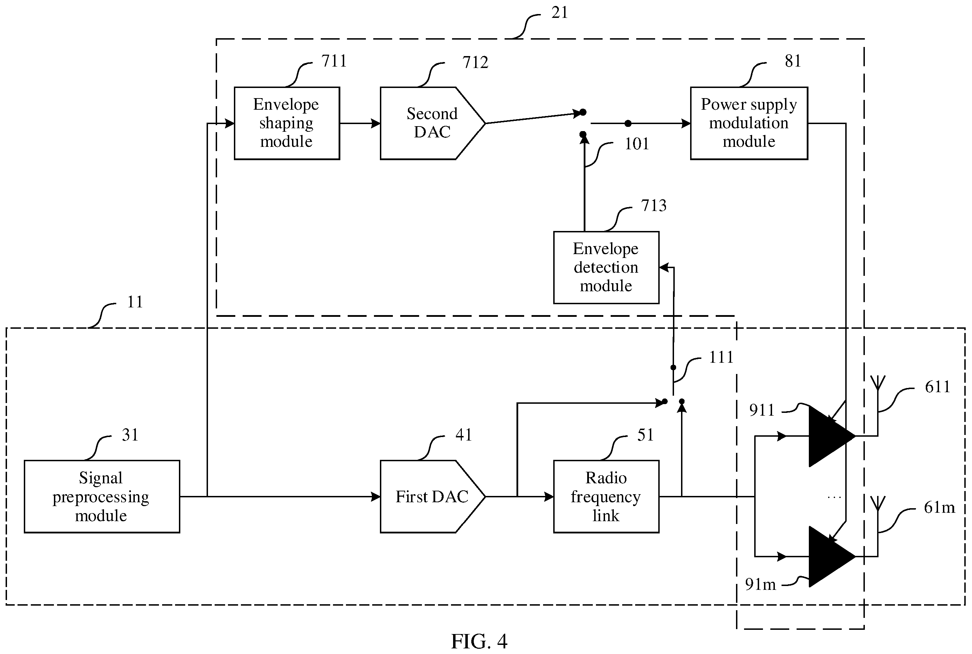

FIG. 4 is a schematic structural diagram of an embodiment 4 of a power amplifier circuit used in a subarray beamforming system according to this application. As shown in FIG. 4, an envelope signal generating circuit is a combination of the envelope signal generating circuits shown in FIG. 2 and FIG. 3, and includes an envelope shaping module 711, a second DAC 712, and an envelope detection module 713. A power amplifier sub-circuit 21 further includes a first switch 101 and a second switch 111. An input end of the envelope shaping module 711 is connected to an output end of a signal preprocessing module 31. The first switch 101 is connected between an output end of the second DAC 712, an output end of the envelope detection module 713, and an input end of a power supply modulation module 81, and the first switch 101 is switched between the output end of the second DAC 712 and the output end of the envelope detection module 713. The second switch 111 is connected between an output end of a first DAC 41, an output end of a radio frequency link 51, and the input end of the envelope detection module 713, and the second switch 111 is switched between the output end of the first DAC 41 and the output end of the radio frequency link 51.

In this application, if a digital envelope signal needs to be generated as shown in FIG. 2, the output end of the second DAC 712 and the input end of the power supply modulation module 81 are connected by using the first switch 101. If an analog envelope signal needs to be generated as shown in FIG. 3, the output end of the envelope detection module 713 and the input end of the power supply modulation module 81 are connected by using the first switch 101, and the output end of the first DAC 41 and the output end of the radio frequency link 51 are switched by using the second switch 111. By using the first switch 101 and the second switch 111, switching between a digital domain envelope signal and an analog domain envelope signal can be implemented, and envelope detection at different locations on a transmit channel can also be implemented, which is convenient and flexible.

In a possible implementation, this application provides a subarray beamforming system. A structure of the system may be shown in FIG. 1, where the system includes a power amplifier circuit. The power amplifier circuit may use a power amplifier circuit structure shown in any one of FIG. 1 to FIG. 4. The subarray module in the subarray beamforming system may use a fixed subarray structure, a phase-shifted subarray structure, a phase-shifted fixed subarray structure, or the like. The following uses the transmit channel 11 and the power amplifier sub-circuit 21 as an example to describe in detail the technical solution of the subarray beamforming system shown in FIG. 1.

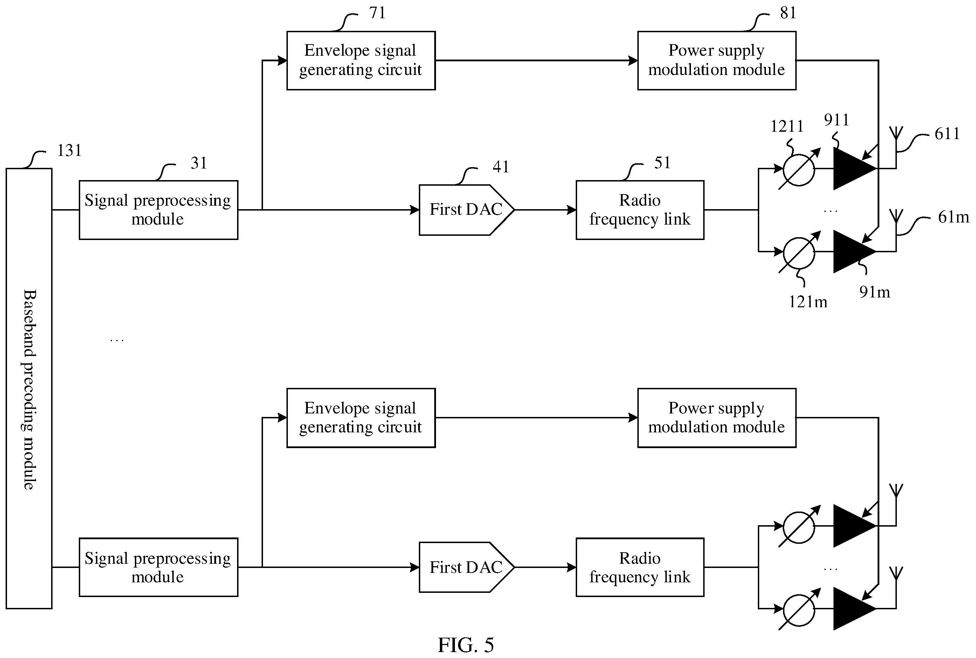

FIG. 5 is a schematic structural diagram of an embodiment 1 of a subarray beamforming system according to this application. As shown in FIG. 5, the system includes a baseband precoding module 131, and an output end of the baseband precoding module 131 is connected to input ends of signal preprocessing modules on transmit channels 11, ..., and 1n. In this way, digital precoding processing is performed on information stream. A subarray module of the transmit channel 11 further includes at least one phase shifter 1211, ..., and 121m. An output end of the phase shifter 1211 is connected to a power amplifier 911, ..., and an output end of the phase shifter 121m is connected to a power amplifier 91m.

In this application, the subarray beamforming system may use a subarray module with a phase-shift subarray structure. Each transmit channel includes one subarray module, each subarray module includes a plurality of antenna array modules, one transmit channel corresponds to one power amplifier sub-circuit, and one antenna array module in each subarray module in the transmit channel corresponds to one power amplifier. Power amplifier units corresponding to subarray modules in different transmit channels use different power supply modulation modules and different envelope signal generating circuits, to generate separate envelope signals for the power amplifier units of the transmit channels. All power amplifiers corresponding to antenna array modules in a subarray module in a same transmit channel use a same power supply modulation module and a same envelope signal generating circuit. According to different actual requirements, envelope signals of the transmit channels may be processed differently, so that envelope tracking power amplifiers work in different states, different effects are achieved, and the power amplification efficiency of the subarray beamforming system is improved. In addition, in an entire design process, a hardware structure of the system does not need to be changed, and compatibility with the conventional technology is achieved to a maximum extent.

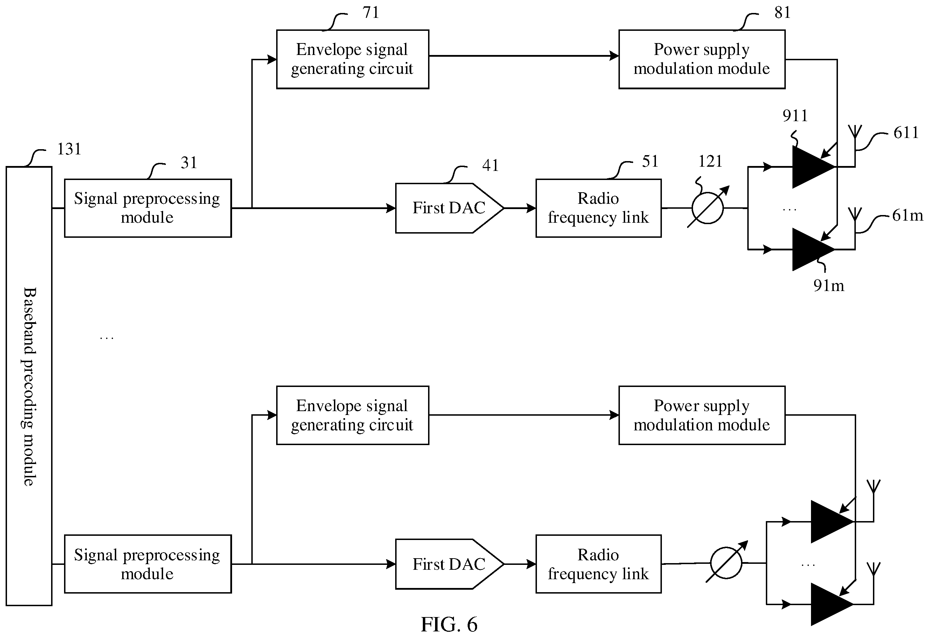

FIG. 6 is a schematic structural diagram of an embodiment 2 of a subarray beamforming system according to this application. As shown in FIG. 6, a subarray module of a transmit channel 11 further includes a phase shifter 121, and output ends of the phase shifter 121 are connected to a power amplifier 911, ..., and a power amplifier 91m.

In this application, the subarray beamforming system may use a subarray module with a phase-shift fixed subarray structure. Each transmit channel includes one subarray module, each subarray module includes a plurality of antenna array modules, one transmit channel corresponds to one power amplifier sub-circuit, and one antenna array module in each subarray module in the transmit channel corresponds to one power amplifier. Power amplifier units corresponding to subarray modules in different transmit channels use different power supply modulation modules and different envelope signal generating circuits, to generate separate envelope signals for the power amplifier units of the transmit channels. All power amplifiers corresponding to antenna array modules in a subarray module in a same transmit channel use a same power supply modulation module and a same envelope signal generating circuit. According to different actual requirements, envelope signals of the transmit channels may be processed differently, so that envelope tracking power amplifiers work in different states, different effects are achieved, and the power amplification efficiency of the subarray beamforming system is improved. In addition, in an entire design process, a hardware structure of the system does not need to be changed, and compatibility with the conventional technology is achieved to a maximum extent.

It should be noted that the power amplifier circuit in the subarray beamforming system shown in FIG. 1, FIG. 5, and FIG. 6 may use a structure of the power amplifier circuit shown in any one of FIG. 1 to FIG. 4. This is not specifically limited in this application.

Finally, it should be noted that the foregoing embodiments are merely intended for describing the technical solutions of this application other than limiting this application. Although this application is described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of the embodiments of this application.

## Claims

1. A subarray beamforming system, comprising a plurality of transmit channels (11, ..., 1n) and a power amplifier circuit,
wherein the power amplifier circuit comprises a plurality of power amplifier sub-circuits (21, ..., 2n), the power amplifier sub-circuit (21, ..., 2n) comprises an envelope signal generating circuit (71), a power supply modulation module (81), and a power amplifier unit that are sequentially connected, and the power amplifier unit comprises at least two power amplifiers (911, ..., 91m);
wherein the plurality of power amplifier sub-circuits (21, ..., 2n) of the power amplifier circuit are in a one-to-one correspondence with the plurality of transmit channels (11, ..., 1n); the transmit channel (11, ..., 1n) comprises a signal preprocessing module (31), a first digital-to-analog converter (41) , a radio frequency link (51), and a subarray module that are sequentially connected, and the subarray module comprises at least two antenna array modules (611, ..., 61m); ;
for each of the transmit channels (11, ..., 1n), an input end of the envelope signal generating circuit (71) in the corresponding power amplifier sub-circuit (21, ..., 2n) is connected to a connection point in the transmit channel (21, ..., 2n), wherein the connection point is disposed an output end of the first digital-to-analog converter (41), or an output end of the radio frequency link (51); and each of the at least two power amplifiers (911, ..., 91m) in the corresponding power amplifier sub-circuit (21, ...2n) is disposed at an input end of a corresponding antenna array module (611, ..., 61m) in the transmit channel (11, ..., 1n), wherein
the signal preprocessing module (31) on the transmit channel (11, ..., 1n) preprocesses a precoded baseband signal, and transmits the preprocessed baseband signal to the connected first digital-to-analog converter (41) and the envelope signal generating circuit (71) that is on the corresponding power amplifier sub-circuit (21, ..., 2n), the first digital-to-analog converter (41) converts the preprocessed baseband signal into an analog signal, and transmits the analog signal to the connected radio frequency link (51); the radio frequency link (51) performs up-conversion, signal amplification, and filtering processing on the analog signal to generate a radio frequency modulation signal, and transmits the radio frequency modulation signal to the at least two antenna array modules (611, ..., 61m); the envelope signal generating circuit (71) generates an envelope signal based on the preprocessed baseband signal, and transmits the envelope signal to the connected power supply modulation module (81); the power supply modulation module (81) generates, under control of the envelope signal, an output voltage that dynamically changes with the envelope signal, and transmits the output voltage to the at least two connected power amplifiers (911, ..., 91m), and the power amplifiers (911, ..., 91m) perform power amplification on the radio frequency modulation signal under modulation of the output voltage; and the antenna array modules (611, ..., 61m) implement analog beamforming and signal transmission;
wherein the envelope signal generating circuit (71) comprises an envelope detection module (713), and an input end of the envelope detection module (713) is connected to the output end of the first digital-to-analog converter (41) or the output end of the radio frequency link (51); and an output end of the envelope detection module (713) is connected to an input end of the power supply modulation module (81).

2. The system according to claim 1, wherein the envelope signal generating circuit (71) further comprises an envelope shaping module (711) and a second digital-to-analog converter (712) that are sequentially connected, and the power amplifier sub-circuit (21, ..., 2n) further comprises a first switch (101) and a second switch (111); an input end of the envelope shaping module (711) is connected to the output end of the signal preprocessing module (31), and the first switch (101)is connected between an output end of the second digital-to-analog converter (712), the output end of the envelope detection module (713), and the input end of the power supply modulation module (81), and the first switch (101) is switched between the output end of the second digital-to-analog converter (712) and the output end of the envelope detection module (713); and the second switch (111) is connected between the output end of the first digital-to-analog converter (41), the output end of the radio frequency link (51), and the input end of the envelope detection module (713), and the second switch (111) is switched between the output end of the first digital-to-analog converter (41) and the output end of the radio frequency link (51).

3. The system according to any one of claims 1 to 2, wherein the subarray module further comprises at least two phase shifters (1211, ..., 121m), and an output end of one phase shifter (1211, ..., 121m) is connected to one power amplifier (911, ..., 91m) in a corresponding power amplifier sub-circuit (21, ..., 2n).

4. The system according to any one of claims 1 to 3, further comprising a baseband precoding module (131), wherein an output end of the baseband precoding module (131) is connected to an input end of a signal preprocessing module (31) on each of the transmit channels (11, ..., 1n).

## Patentansprüche

1. Subarray-Strahlformungssystem, umfassend eine Mehrzahl von Sendekanälen (11, ..., 1n ) und eine Leistungsverstärkerschaltung,
wobei die Leistungsverstärkerschaltung eine Mehrzahl von Leistungsverstärker-Teilschaltungen (21, ..., 2n) umfasst, die Leistungsverstärker-Teilschaltung (21, ..., 2n) eine Hüllkurvensignalerzeugungsschaltung (71), ein Leistungsversorgungsmodulationsmodul (81) und eine Leistungsverstärkungseinheit umfasst, die hintereinandergeschaltet sind, und die Leistungsverstärkereinheit mindestens zwei Leistungsverstärker (911, ..., 91m) umfasst;
wobei die Mehrzahl von Leistungsverstärker-Teilschaltungen (21, ..., 2n) der Leistungsverstärkerschaltung in einer Eins-zu-eins-Entsprechung mit der Mehrzahl von Sendekanälen (11, ..., 1n) steht; der Sendekanal (11, ..., 1n) ein Signalvorverarbeitungsmodul (31), einen ersten Digital-Analog-Wandler (41), eine Hochfrequenzverbindung (51) und ein Subarray-Modul umfasst, die hintereinandergeschaltet sind, und das Subarray-Modul mindestens zwei Antennenarray-Module (611, ..., 61m) umfasst;
für jeden der Sendekanäle (11, ..., 1n) ein Eingangsende der Hüllkurvensignalerzeugungsschaltung (71) in der entsprechenden Leistungsverstärker-Teilschaltung (21, ..., 2n) mit einem Verbindungpunkt in dem Sendekanal (21, ..., 2n) verbunden ist, wobei der Verbindungspunkt an einem Ausgangsende des ersten Digital-Analog-Wandlers (41) oder einem Ausgangsende der Hochfrequenzverbindung (51) angeordnet ist; und jeder der mindestens zwei Leistungsverstärker (911, ..., 91m) in der entsprechenden Leistungsverstärker-Teilschaltung (21, ..., 2n) an einem Eingangsende eines entsprechenden Antennenarray-Moduls (611, ..., 61m) in dem Sendekanal (11, ..., 1n) angeordnet ist, wobei
das Signalvorverarbeitungsmodul (31) auf dem Sendekanal (11, ..., 1n) ein vorcodiertes Basisbandsignal vorverarbeitet und das vorverarbeitete Basisbandsignal an den verbundenen ersten Digital-Analog-Wandler (41) und die Hüllkurvensignalerzeugungsschaltung (71) sendet, die auf der entsprechenden Leistungsverstärker-Teilschaltung (21, ..., 2n) ist, der erste Digital-Analog-Wandler (41) das vorverarbeitete Basisbandsignal in ein analoges Signal umwandelt und das analoge Signal an die verbundene Hochfrequenzverbindung (51) sendet; die Hochfrequenzverbindung (51) Aufwärtsmischungs-, Signalverstärkungs- und Filterverarbeitung an dem analogen Signal durchführt, um ein Hochfrequenzmodulationssignal zu erzeugen, und das Hochfrequenzmodulationssignal an die mindestens zwei Antennenarray-Module (611, ..., 61m) sendet; die Hüllkurvensignalerzeugungsschaltung (71) basierend auf dem vorverarbeiteten Basisbandsignal ein Hüllkurvensignal erzeugt und das Hüllkurvensignal an das verbundene Leistungsversorgungsmodulationsmodul (81) sendet; das Leistungsversorgungsmodulationsmodul (81) unter der Kontrolle des Hüllkurvensignals eine Ausgangsspannung erzeugt, die sich mit dem Hüllkurvensignal dynamisch ändert, und die Ausgangsspannung an die mindestens zwei verbundenen Leistungsverstärker (911, ..., 91m) sendet, und die Leistungsverstärker (911, ..., 91m) Leistungsverstärkung an dem Hochfrequenzmodulationssignal unter Modulation der Ausgangsspannung durchführen; und die Antennenarray-Module (611, ..., 61m) analoge Strahlformung und Signalübertragung implementieren;
wobei die Hüllkurvensignalerzeugungsschaltung (71) ein Hüllkurvendetektionsmodul (713) umfasst und ein Eingangsende des Hüllkurvendetektionsmoduls (713) mit dem Ausgangsende des ersten Digital-Analog-Wandlers (41) oder dem Ausgangsende der Hochfrequenzverbindung (51) verbunden ist; und ein Ausgangsende des Hüllkurvendetektionsmoduls (713) mit einem Eingangsende des Leistungsversorgungsmodulationsmoduls (81) verbunden ist.

2. System nach Anspruch 1, wobei die Hüllkurvensignalerzeugungsschaltung (71) ferner ein Hüllkurvenformungsmodul (711) und einen zweiten Digital-Analog-Wandler (712) umfasst, die hintereinandergeschaltet sind, und die Leistungsverstärker-Teilschaltung (21, ..., 2n) ferner einen ersten Schalter (101) und einen zweiten Schalter (111) umfasst; ein Eingangsende des Hüllkurvenformungsmoduls (711) mit dem Ausgangsende des Signalvorverarbeitungsmoduls (31) verbunden ist und der erste Schalter (101) zwischen ein Ausgangsende des zweiten Digital-Analog-Wandlers (712), das Ausgangsende des Hüllkurvendetektionsmoduls (713) und das Eingangsende des Leistungsversorgungsmodulationsmoduls (81) geschaltet ist, und der erste Schalter (101) zwischen das Ausgangsende des zweiten Digital-Analog-Wandlers (712) und das Ausgangsende des Hüllkurvendetektionsmoduls (713) geschaltet ist; und der zweite Schalter (111) zwischen das Ausgangsende des ersten Digital-Analog-Wandlers (41), das Ausgangsende der Hochfrequenzverbindung (51) und das Eingangsende des Hüllkurvendetektionsmoduls (713) geschaltet ist, und der zweite Schalter (111) zwischen das Ausgangsende des ersten Digital-Analog-Wandlers (41) und das Ausgangsende der Hochfrequenzverbindung (51) geschaltet ist.

3. System nach einem der Ansprüche 1 bis 2, wobei das Subarray-Modul ferner mindestens zwei Phasenschieber (1211, ..., 121m) umfasst und ein Ausgangsende eines Phasenschiebers (1211, ..., 121m) mit einem Leistungsverstärker (911, ..., 91m) in einer entsprechenden Leistungsverstärker-Teilschaltung (21, ..., 2n) verbunden ist.

4. System nach einem der Ansprüche 1 bis 3, ferner umfassend ein Basisband-Vorcodierungsmodul (131), wobei ein Ausgangsende des Basisband-Vorcodierungsmoduls (131) mit einem Eingangsende eines Signalvorverarbeitungsmoduls (31) auf jedem der Sendekanäle (11, ..., 1n) verbunden ist.

## Revendications

1. Système de formation de faisceaux de sous-réseau, comprenant une pluralité de canaux d'émission (11, ..., 1n) et un circuit amplificateur de puissance,
dans lequel le circuit amplificateur de puissance comprend une pluralité de sous-circuits amplificateurs de puissance (21, ..., 2n), le sous-circuit amplificateur de puissance (21, ..., 2n) comprend un circuit générateur de signal d'enveloppe (71), un module de modulation d'alimentation (81) et une unité amplificatrice de puissance qui sont connectés séquentiellement, et l'unité amplificatrice de puissance comprend au moins deux amplificateurs de puissance (911, ..., 91m) ;
dans lequel la pluralité de sous-circuits amplificateurs de puissance (21, ..., 2n) du circuit amplificateur de puissance sont en correspondance biunivoque avec la pluralité de canaux d'émission (11, ..., 1n); le canal d'émission (11, ..., 1n) comprend un module de prétraitement de signal (31), un premier convertisseur numérique-analogique (41), une liaison radiofréquence (51) et un module de sous-réseau qui sont connectés séquentiellement, et le module de sous-réseau comprend au moins deux modules de réseau d'antennes (611, ..., 61m) ;
pour chacun des canaux d'émission (11, ..., 1n), une extrémité d'entrée du circuit de génération de signal d'enveloppe (71) dans le sous-circuit amplificateur de puissance correspondant (21, ..., 2n) est connectée à un point de connexion dans le canal d'émission (21, ..., 2n), où le point de connexion est disposé à une extrémité de sortie du premier convertisseur numérique-analogique (41) ou à une extrémité de sortie de la liaison radiofréquence (51) ; et chacun des au moins deux amplificateurs de puissance (911, ..., 91m) dans le sous-circuit amplificateur de puissance correspondant (21, ...2n) est disposé à une extrémité d'entrée d'un module d'antenne réseau correspondant (611, ..., 61m) dans le canal d'émission (11, ..., 1n), où :
le module de prétraitement de signal (31) sur le canal d'émission (11, ..., 1n) prétraite un signal en bande de base précodé, et transmet le signal en bande de base prétraité au premier convertisseur numérique-analogique connecté (41) et au circuit de génération de signal d'enveloppe (71) qui se trouve sur le sous-circuit amplificateur de puissance correspondant (21, ..., 2n), le premier convertisseur numérique-analogique (41) convertit le signal en bande de base prétraité en un signal analogique et transmet le signal analogique à la liaison radiofréquence connectée (51) ; la liaison radiofréquence (51) effectue une conversion ascendante, une amplification du signal et un traitement de filtrage sur le signal analogique afin de générer un signal de modulation radiofréquence, et transmet le signal de modulation radiofréquence aux au moins deux modules d'antennes réseau (611, ..., 61m) ; le circuit de génération de signal d'enveloppe (71) génère un signal d'enveloppe sur la base du signal en bande de base prétraité et transmet le signal d'enveloppe au module de modulation d'alimentation connecté (81) ; le module de modulation d'alimentation (81) génère, sous le contrôle du signal d'enveloppe, une tension de sortie qui change dynamiquement avec le signal d'enveloppe, et transmet la tension de sortie aux au moins deux amplificateurs de puissance connectés (911, ..., 91m), et les amplificateurs de puissance (911, ..., 91m) effectuent une amplification de puissance sur le signal de modulation radiofréquence sous la modulation de la tension de sortie ; et les modules d'antennes réseau (611, ..., 61m) mettent en œuvre la formation de faisceaux analogiques et l'émission de signaux ;
où le circuit de génération de signal d'enveloppe (71) comprend un module de détection d'enveloppe (713), et une extrémité d'entrée du module de détection d'enveloppe (713) est connectée à l'extrémité de sortie du premier convertisseur numérique-analogique (41) ou à l'extrémité de sortie de la liaison radiofréquence (51) ; et une extrémité de sortie du module de détection d'enveloppe (713) est connectée à une extrémité d'entrée du module de modulation d'alimentation (81),

2. Système selon la revendication 1, dans lequel le circuit de génération de signal d'enveloppe (71) comprend en outre un module de mise en forme d'enveloppe (711) et un deuxième convertisseur numérique-analogique (712) qui sont connectés séquentiellement, et le sous-circuit amplificateur de puissance (21, ..., 2n) comprend en outre un premier commutateur (101) et un deuxième commutateur (111) ; une extrémité d'entrée du module de mise en forme d'enveloppe (711) est connectée à l'extrémité de sortie du module de prétraitement de signal (31), et le premier commutateur (101) est connecté entre une extrémité de sortie du deuxième convertisseur numérique-analogique (712), l'extrémité de sortie du module de détection d'enveloppe (713) et l'extrémité d'entrée du module de modulation d'alimentation (81), et le premier commutateur (101) est commuté entre l'extrémité de sortie du deuxième convertisseur numérique-analogique (712) et l'extrémité de sortie du module de détection d'enveloppe (713) ; et le deuxième commutateur (111) est connecté entre l'extrémité de sortie du premier convertisseur numérique-analogique (41), l'extrémité de sortie de la liaison radiofréquence (51) et l'extrémité d'entrée du module de détection d'enveloppe (713), et le deuxième commutateur (111) est commuté entre l'extrémité de sortie du premier convertisseur numérique-analogique (41) et l'extrémité de sortie de la liaison radiofréquence (51).

3. Système selon l'une quelconque des revendications 1 et 2, dans lequel le module de sous-réseau comprend en outre au moins deux déphaseurs (1211, ..., 121m), et une extrémité de sortie d'un déphaseur (1211, ..., 121m) est connectée à un amplificateur de puissance (911, ..., 91m) dans un sous-circuit d'amplificateur de puissance correspondant (21, ..., 2n).

4. Système selon l'une quelconque des revendications 1 à 3, comprenant en outre un module de précodage en bande de base (131), dans lequel une extrémité de sortie du module de précodage en bande de base (131) est connectée à une extrémité d'entrée d'un module de prétraitement de signal (31) sur chacun des canaux d'émission (11, ... , 1n).
